(19) Europäisches Patentamt
European Patent Office
Office européen des brevets

(11) **EP 2 348 326 B1**

## (12) EUROPÄISCHE PATENTSCHRIFT

(45) Veröffentlichungstag und Bekanntmachung des Hinweises auf die Patenterteilung:
**02.08.2017** **Patentblatt 2017/31**

(51) Int Cl.:
**G01R 19/25** (2006.01)  **G08C 23/00** (2006.01)
**H04Q 9/00** (2006.01)

(21) Anmeldenummer: **11000135.1**

(22) Anmeldetag: **11.01.2011**

(54) **Stromsensoreinheit und Verfahren zur Signal-und/ oder Datenübertragung**

Current sensor unit and method for signal and/or data transfer

Unité de capteur de courant et procédé de transmission de signal et/ou de données

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.01.2010  DE 102010004350**
**28.01.2010  DE 102010006227**

(43) Veröffentlichungstag der Anmeldung:
**27.07.2011  Patentblatt 2011/30**

(73) Patentinhaber: **Gesellschaft für Antriebs- und Energietechnik,**
**Regelungs- und Automatisierungssysteme mbH**
**38678 Claustahl-Zellerfeld (DE)**

(72) Erfinder: **Sourkounis, Constantinos**
**38678 Clausthal-Zellerfeld (DE)**

(74) Vertreter: **Rebbereh, Cornelia**
**Kamper Strasse 1**
**51789 Lindlar (DE)**

(56) Entgegenhaltungen:
**DE-A1- 10 027 092   US-A- 3 766 497**
**US-A- 5 990 661   US-A1- 2003 235 246**
**US-A1- 2005 052 249**

• **ABDOULKARIM BOUABANA ET AL: "A low-cost current sensor with a novel modulated interface (F-PWM)", ELECTRONICS, CIRCUITS, AND SYSTEMS (ICECS), 2010 17TH IEEE INTERNATIONAL CONFERENCE ON, IEEE, 12. Dezember 2010 (2010-12-12), Seiten 802-806, XP031923076, DOI: 10.1109/ICECS.2010.5724634 ISBN: 978-1-4244-8155-2**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Stromsensoreinheit mit potentialfreier Signalübertragung sowie ein Verfahren zur Signal- und/oder Datenübertragung. Leistungselektronische Einrichtungen und Komponenten haben in alle Bereiche der Energieversorgung und der Antriebstechnik sowie in den vergangenen Jahren verstärkt auch in den Bereich des Automobils Einzug gehalten. Hierdurch haben sich neue Anforderungen an die Sensorik für die Messung elektrischer Größen, wie insbesondere die Messung von Strom, ergeben.

Durch den diskontinuierlichen Betrieb der Leistungselektronik unterliegen verwendete Sensoren einem schwebenden Potential mit Gradienten von bis zu 6 kV/$\mu$s, die grundsätzlich zu Ladungsverschiebungen bei parasitären Koppelkapazitäten führen. Hierdurch kann es zu einer Beeinträchtigung der Funktion der Sensoren kommen und insbesondere bei solchen ohne Potentialtrennung. Aufgrund von Schaltvorgängen und der damit verbundenen dynamischen Potentialverschiebung ergibt sich die Notwendigkeit, jede indirekte Strommessung über einen Spannungsabfall auf der sog. High-Seite durchzuführen. Dies ergibt sich aus der Anforderung, dynamische Potentialverschiebungen des 0 V-Bezugspotentials innerhalb der geometrischen Ausdehnung des Energieversorgungssystems, wie beispielsweise des Bordnetzes eines Fahrzeugs, möglichst zu vermeiden. Druckschrift DE10027092A1 offenbart einen analogen Signaldetektionsschaltkreis, der durch Verwenden einer Trägerschwingung ein analoges Eingangssignal direkt pulsbreitenmoduliert und als digitales Signal weitergibt. Im Ergebnis lässt sich ein analoges Signal selbst in dem Fall detektieren, in dem sich Referenzpotentiale voneinander bei Signaleingangs/Ausgangsanschlüssen unterscheiden.

Der vorliegenden Erfindung liegt daher die Aufgabe zugrunde, eine Stromsensoreinheit sowie ein Verfahren zur Signal- und/oder Datenübertragung vorzusehen, mittels derer eine potentialfreie Messung und Datenübertragung von Messsignalen zu einer Steuerelektronik möglich ist.

Die Aufgabe wird durch eine Stromsensoreinheit nach dem Oberbegriff des Anspruchs 1 dadurch gelöst, dass zumindest ein Shunt und zumindest ein Erfassungsmodul zum Erfassen einer Messgröße, zumindest ein Modulationsmodul zur Frequenz-Pulsweiten-Modulation und zumindest ein potentialfreies Übertragungsmodul vorgesehen sind. Für ein Verfahren zur Signal- und/oder Datenübertragung wird die Aufgabe dadurch gelöst, dass zur Codierung einer Messgröße eine Frequenz-Pulsweiten-Modulation erfolgt, wobei 8 Bit der Messgröße in eine Pulsweite und 8 Bit der Messgröße in eine Frequenz codiert werden. Weiterbildungen der Erfindung sind in den abhängigen Ansprüchen definiert.

Dadurch wird eine Stromsensoreinheit mit potentialfreier Signalübertragung geschaffen, mittels derer ein potentialfreier Anschluss an eine Steuerelektronik möglich ist. Die Stromsensoreinheit kann bei beliebigen Messungen bei einem schwebenden Potential mit einem Gradienten von bis zu 6 kV/$\mu$s oder ggf. auch höher eingesetzt werden. Eine potentialfreie Übertragung von Messdaten, insbesondere eines Stromsignals, kann insbesondere über eine optische und/oder magnetische Übertragungsstrecke erfolgen. Die Übertragung wird realisiert durch einen vorteilhaften Mikrocontroller als Modul zur Signal- und/oder Datenmodulation, ein Übertragungsmodul mit einer Sendeeinheit, der potentialfreien Übertragungsstrecke, einer Empfangseinheit, und eine Hilfsenergieversorgungseinrichtung. Bei Vorsehen einer optischen Übertragungsstrecke kann der Vorteil einer hohen elektromagnetischen Verträglichkeit (EMV) erzielt werden. In Verbindung mit der besonders guten elektromagnetischen Verträglichkeit kann die Stromsensoreinheit auch in Umgebungen mit extrem hohen und dynamischen elektromagnetischen Feldern vorgesehen werden. Die optische Übertragungsstrecke kann insbesondere zumindest durch einen Optokoppler und/oder einen Lichtwellenleiter realisiert werden.

Optische und/oder magnetische potentialfreie Übertragungsstrecken weisen eine nichtlineare Charakteristik und bei der Übertragung von analogen Signalen eine oftmals unzureichende Genauigkeit auf. Um dieses Problem zu lösen, ist das Modulationsmodul zur Frequenz-Pulsweiten-Modulation ausgebildet, auf deren Basis die optische Übertragung erfolgt. Dies ist eine Pulsmodulation des Signals, die insbesondere über einen Mikrocontroller als Modulationsmodul für die Modulation des Messsignals bzw. der Messgröße erfolgt. Die Messgröße wird zunächst gespiegelt und nachfolgend durch die Frequenz-Pulsweiten-Modulation codiert. Bei der Frequenz-Pulsweiten-Modulation werden 8 Bit der Messgröße in eine Pulsweite und 8 Bit der Messgröße in eine Frequenz codiert. Bei einer solchen Frequenz- und Pulsweiten-Modulation ist somit eine Auflösung von 16 Bit einer Messgröße bzw. eines Messsignals vorgesehen. Die Datenübertragungsstrecke für die Sensoreinheit dient dazu, Messgrößen bzw. Messsignale von der Leistungseinheit, wie leistungselektronischen Einrichtungen, die den zu erfassenden Strom führt, an eine Visualisierungs-, Steuer- oder Automatisierungseinheit zu senden. Um eine Verfälschung des zu übertragenden Signals möglichst zu vermeiden, erweist sich die 16 Bit-Auflösung der Messgröße als besonders geeignet.

Durch die Verwendung der Frequenz-Pulsweiten-Modulation werden keine besonderen Anforderungen an die Steuerelektronik mehr gestellt. Das von der Stromsensoreinheit erfasste Stromsignal kann vielmehr nach der Frequenz- und Pulsweiten-Modulation direkt oder nach einer Mittelwertbildung zur Demodulation als Analogsignal von der Steuerelektronik ausgewertet werden. Zur Demodulation können zumindest ein Demodulationsmodul und/oder eine Softwareroutine vorgesehen sein. Ferner ist es möglich, das ausgegebene frequenz-pulsweitenmodulierte Signal direkt einem Mikrocontroller zuzuführen. In diesem kann das Signal über eine sog. Capture-Compare-Einheit und/oder über einen digitalen Eingang eingelesen und ausgewertet werden.

Bei Bedarf eines Analogsignals erfolgt eine Demodulation des frequenz-pulsweiten-modulierten Signals in dem Demodulationsmodul. Die Demodulation des Signals kann z.B. durch eine Mittelwertbildung mit geringem Aufwand realisiert werden. Der Signalverlauf des Stroms sowie der jeweilige Betrag liegen nachfolgend als analoges Spannungssignal vor, so dass ein Einlesen und Verwerten dieses Spannungssignals durch eine analoge Steuerelektronik zum Zwecke der Überwachung, Steuerung und Regelung problemlos möglich ist. Das sich hier ergebende analoge Spannungssignal, das als Spannungsabfall am Shunt gemessen wird, kann wie erwähnt entweder direkt in eine analoge Steuerelektronik eingegeben werden oder bei Vorsehen einer mikrocontrollerbasierten Steuereinheit über einen AD-Wandler eingelesen und nachfolgend verarbeitet werden. Dadurch ist es möglich, die Stromsensoreinheit anstelle herkömmlicher Stromsensoren, wie beispielsweise Hall-Sensoren, mit einem analogen Ausgangssignal vorzusehen. Die Stromsensoreinheit ist mit allen Stromsensoren vom ausgegebenen Signal her kompatibel, die über ein analoges Ausgangssignal verfügen, so dass die Stromsensoreinheit alle diese Stromsensoren grundsätzlich ersetzen kann.

Der bei der Stromsensoreinheit verwendete Shunt ist ein Präzisionswiderstand. Dieser ist insbesondere niederohmig, induktivitätsarm und alterungsbeständig und weist einen extrem niedrigen Temperaturkoeffizienten auf. Der Shunt ist eine passive Komponente, die den maximal zu messenden Strom bestimmt. Zum Erfassen der an diesem abfallenden Spannung ist das Erfassungsmodul vorgesehen. Dieses kann ein herkömmlicher Analog-Digital-Wandler oder ein spezieller, wie beispielsweise der ASIC IHM-A-1500 der Isabellenhütte Heusler GmbH & Co. KG, 35683 Dillenburg, Deutschland, sein. Der als zu messende Größe über den Shunt fließende Strom führt zu einem proportionalen Spannungsabfall, der über den Shunt erfasst wird. Der maximal zu messende Strom kann über die Größe und Bauart des Shunts bestimmt werden. Hierdurch ist es möglich, den sonstigen Aufbau der Stromsensoreinheit, also deren Elektronik, unabhängig von dem maximal zu messenden Strom auszulegen. Eine Auslegung erfolgt nur über den Shunt, so dass hier eine kostengünstige und wenig aufwändige Anpassung möglich ist.

Das Vorsehen eines modularen Aufbaus führt entsprechend zu dem Vorteil, dass der Einsatz in einem großen Strombereich ohne nennenswerte technische Änderungen an der Stromsensoreinheit realisiert werden kann. Eine solche Anpassung an verschiedene Ströme ist, wie erwähnt, allein durch die Anpassung der Komponente des Shunts möglich. Zur Anpassung kann dieser unterschiedlich ausgelegt werden. Da eine Anpassung an unterschiedliche Messbereiche des zu erfassenden Stroms lediglich über den Shunt erfolgt, bleibt das elektronische Teilsystem, das für die Erfassung, Aufbereitung und Übertragung des Stromistwert-Signals zuständig ist, von der Höhe und dem dynamischen Zeitverlauf des Stromsignals bezüglich der Funktionen, Schaltungstopologie und Höhe der erforderlichen einzusetzenden Hilfsenergie unbeeinflusst. Hierdurch kann eine Feinabstufung der Messbereiche problemlos ohne Mehrkosten auf einfache Art und Weise erfolgen. Eine Anpassung der Abstufungen der Messbereiche ist jederzeit somit anwendungsspezifisch möglich. Entsprechend ist ein breiter Einsatzbereich für die Stromsensoreinheit bis zu einigen kA möglich.

Insbesondere weist die Stromsensoreinheit ein geringes spezifisches Bauvolumen ebenso wie ein geringes Gewicht auf, so dass diese problemlos in jeglicher Art von leistungselektronischen Einrichtungen sowie in Antriebs- und Energieversorgungssystemen für mobile und stationäre Anwendungen integriert werden kann. Aufgrund des potentialfreien Anschlusses an die Steuerelektronik können ferner die Anforderungen an eine Automatisierungseinheit bzw. das auswertende System reduziert werden. Bei einem nicht potentialfreien Anschluss zur Steuerelektronik müssten hier Maßnahmen ergriffen werden, um dynamische Potentialverschiebungen des 0 V-Bezugspotentials zu vermeiden. Vorliegend wird jedoch ein sicherer Betrieb auch bei schwebendem Potential mit hohen Gradienten gewährleistet. Die Anforderungen an das Schaltungslayout und die Anforderungen bezüglich der Spannungsfestigkeit der Eingangsverstärkerstufe im Pfad des Stromistwert-Signals können somit aufgrund des Vorsehens des potentialfreien Anschlusses zur Steuerelektronik gegenüber dem Stand der Technik reduziert werden. Gerade für den mobilen Einsatz der Stromsensoreinheit erweist sich auch der niedrige Hilfsenergiebedarf als besonders vorteilhaft.

Vorteilhaft ist zum Erfassen der am Shunt erfassten stromproportionalen Spannung ein Spannungserfassungsmodul insbesondere in Form eines ASIC IHM-A-1500 mit einer programmierbaren Verstärkereinheit zum Erzielen einer hohen Auflösung vorgesehen und/oder das Spannungserfassungsmodul zum dynamischen Umschalten seines Messbereichs zum Erzielen einer hohen Genauigkeit ausgebildet. Gerade in Bordnetzen von Fahrzeugen und einer Reihe weiterer Anwendungsgebiete der industriellen Messtechnik kann eine solche Stromsensoreinheit daher besonders gut eingesetzt werden. Durch das Vorsehen der programmierbaren Verstärkereinheit kann bei Verstärkungswerten von beispielsweise 1, 6, 24, 50 und 100 ein extrem weiter Eingangsbereich von beispielsweise +/-7,5 mV bis +/-750 mV abgedeckt werden, so dass sich sehr hohe Auflösungen hier realisieren lassen. Beispielsweise kann die Auflösung der Stromsensoreinheit bei einem maximalen Spannungseingangssignal von +/-30 mV für einen Strommessbereich von +/-300 A etwa 10 mA betragen, so dass also eine sehr hohe Auflösung hier realisierbar ist.

Im Vergleich zu den bisherigen Stromsensoren auf Basis des Halleffekts weist die vorliegende Stromsensoreinheit neben dem Vorteil einer hohen Genauigkeit ein geringes Gewicht und Bauvolumen, wie bereits erwähnt, sowie einen vergleichsweise niedrigen Energieeigenverbrauch auf. Die Stromsensoreinheit ist daher besonders für den Einsatz in Verkehrssystemen geeignet, die einen ständig steigenden Bedarf an potentialfreien Stromsensoren haben.

Bei der Demodulation durch einen oder den vorteilhaft vorgesehenen Mikrocontroller werden weiter vorteilhaft die zwei Zeiten zwischen zwei steigenden Flanken des Messsignals und der Zeitpunkt des Umschaltens des Signals von High auf Low erfasst. Ferner werden aus der Periodendauer oder Frequenz ein oberer 8-Bit-Wert und aus der Pulsdauer in Relation zu der Periodendauer des Messsignals ein unterer 8-Bit-Wert rückgerechnet. Weiter können der obere und der untere 8-Bit-Wert in einem 16-Bit-Speicher in binärer Form eingeschrieben und/oder in eine Hexadezimalzahl umgewandelt und ausgegeben werden.

Die Frequenz-Pulsweiten-Modulation wird anstelle einer Pulsweiten-Modulation, also einer einfachen Modulation, verwendet, da bei dieser bei einer beispielsweise 16-Bit-Auflösung des zu übertragenden Signals sich eine sehr hohe Frequenz im Bereich von 2 GHz ergäbe. Im bezahlbaren bzw. niederpreisigen Bereich gibt es jedoch keine Mikrocontroller, die eine solche Taktfrequenz zulassen, so dass das Splitten des 16-Bit-Messwertes in zwei 8-Bit-Messbereiche hier zu einer sehr viel geringeren Frequenz von insbesondere 8 MHz führt. Durch die Taktfrequenz des auszuwertenden Mikrocontrollers wird auch die maximal mögliche zeitliche Auflösung des modulierten Signals bestimmt.

Zur näheren Erläuterung der Erfindung werden im Folgenden Ausführungsbeispiele von dieser näher anhand der Zeichnungen beschrieben. Diese zeigen in:

Figur 1    eine Prinzipskizze einer erfindungsgemäßen Stromsensoreinheit,

Figur 2    eine Prinzipskizze einer Anbindung der Stromsensoreinheit an eine Steuerelektronik über einen Optokoppler und eine herkömmliche Leitung,

Figur 3    eine Prinzipskizze einer Anbindung der Stromsensoreinheit an eine Steuerelektronik über Lichtwellenleiter,

Figur 4    ein Funktionsblockschaltbild einer erfindungsgemäßen Stromsensoreinheit mit einer Anbindung an einen Mikrocontroller der Stromsensoreinheit, Demodulation durch den Mikrocontroller auf der Basis einer Demodulationssoftwareroutine,

Figur 5    ein Diagramm einer minimalen und maximalen Pulsdauer bei einer Frequenz-Pulsweiten-Modulation, und

Figur 6    ein Diagramm des Frequenz-Pulsweiten-Modulationssignals sowie der Taktzeiten bei der Auswertung des Frequenz-Pulsweiten-Modulationssignals.

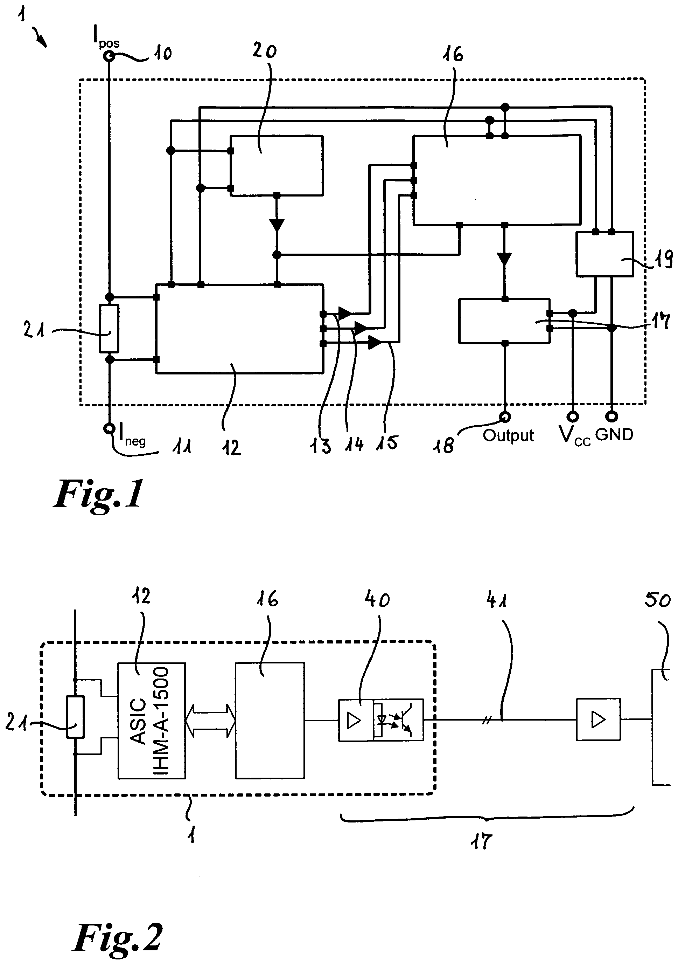

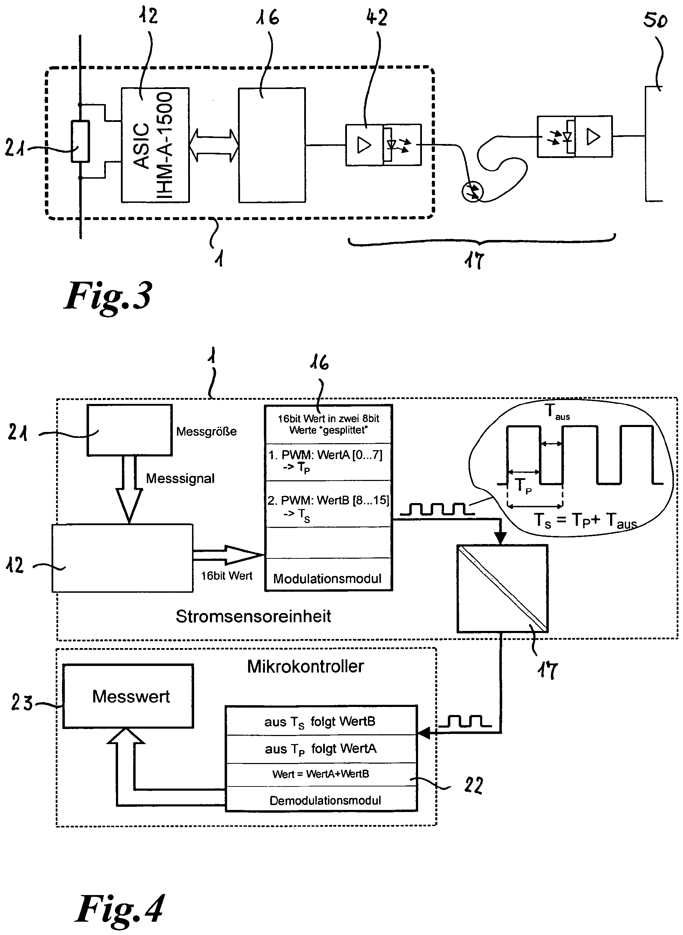

Figur 1 zeigt eine Prinzipskizze des Aufbaus einer Stromsensoreinheit 1. Diese umfasst zwei Stromanschlüsse 10, 11, die mit einem Shunt 21 verbunden sind. An diesem fällt eine Spannung ab, die von einem Erfassungsmodul 12 erfasst wird. Der Shunt ist daher zur Erfassung des Spannungsabfalls an diesem mit dem Erfassungsmodul 12 verbunden. Dieser ist wiederum über Datenleitungen 13, 14, 15 mit einem Modulationsmodul 16 verbunden, insbesondere über eine serielle Schnittstelle. Das modulierte Signal kann über ein potentialfreies Übertragungsmodul 17 zu einem Ausgang 18 übertragen und dort ausgegeben werden. Die potentialfreie Übertragungsstrecke des Übertragungsmoduls 17 kann als optische und/oder magnetische Strecke realisiert sein, wobei in den Figuren 2 und 3 jeweils Ausführungsvarianten einer optischen Übertragungsstrecke gezeigt sind.

Die in Figur 1 gezeigte Ausführungsform der Stromsensoreinheit umfasst ferner eine Hilfsenergieversorgungseinrichtung 19 mit einem DC/DC-Wandler zur potentialfreien Energieversorgung, der über die Anschlüsse $V_{cc}$ und GND Energie zugeführt wird. Die Stromsensoreinheit wird an eine Spannungsquelle mit einer konstanten oder variablen Spannung oder alternativ an eine externe Hilfsenergieversorgungseinrichtung angeschlossen, ebenfalls über die Anschlüsse $V_{cc}$ und GND. Die Hilfsenergieversorgungseinrichtung_19 ist über Leitungen mit dem Modulationsmodul sowie einem Quarzoszillator 20 verbunden. Dessen Signal wird als Taktgeber für die Modulation verwendet, so dass dessen Ausgangssignal über eine Leitung dem Modulationsmodul 16 zugeführt wird. Eine weitere Leitung führt zu dem Erfassungsmodul 12.

Das Erfassungsmodul 12 ist insbesondere als Signal- und Datenwandler in Form eines AD-Wandlers, insbesondere ASIC IHM-A-1500 der Isabellenhütte Heusler GmbH & Co. KG verwirklicht, der ein spezieller Analog-Digital-Wandler ist. Dem Shunt 21 ist das Erfassungsmodul 12 zum Erfassen der abfallenden Spannung zugeordnet. In den Figuren 2 und 3 sind ein jeweiliger entsprechender Shunt 21 mit Erfassungsmodul 12 und Modulationsmodul 16 gezeigt.

Die in Figur 2 gezeigte Stromsensoreinheit 1 umfasst einen Optokoppler 40 sowie eine herkömmliche Leitung 41, die zusammen Teil des Übertragungsmoduls 17 sind, zum Verbinden der Stromsensoreinheit 1 mit einer Steuerelektronik 50. Demgegenüber ist bei der Ausführungsform der Stromsensoreinheit gemäß Figur 3 ein Lichtwellenleiter 42 als optische Übertragungsstrecke des Übertragungsmoduls 17 vorgesehen. In beiden Fällen wird somit eine optische Übertragungsstrecke als potentialfreie Übertragungsstrecke realisiert. Die in Figur 2 gezeigte Variante unter Verwendung eines Optokopplers ist mit geringeren Kosten verbunden als die in Figur 3 gezeigte. Bei der Verwendung von Optokopplern wird deren wirksame parasitäre Kapazität so weit kompensiert bzw. reduziert, dass im Wesentlichen keine nennenswerten Ladungsverschiebungen während der Schaltvorgänge auftreten, so dass die Funktionsfähigkeit und Genauigkeit der Stromsensoreinheit gewährleistet werden kann. Ladungsverschiebungen treten üblicherweise mit steigenden Spannungsgradienten in Erscheinung, die insbesondere zur Reduzierung von Schaltverlusten und zur Erhöhung der Leistungsdichte bei leistungselektronischen Einrichtungen angestrebt werden. Derartige leistungselektronische Einrichtungen finden sich gerade in Verkehrssystemen, da sie ein geringes Volumen und Gewicht aufweisen. Die Ausführungsvariante nach Figur 2 eignet sich dadurch besonders für die Verwendung in Verkehrssystemen.

Bei der in Figur 3 gezeigten Verwendung eines Lichtwellenleiters 42wird optimalerweise darauf geachtet, robuste Lichtwellenleiter zu verwenden, um eine Beschädigung von diesen bei mechanischen Beanspruchungen möglichst zu vermeiden. Der Energiebedarf für die Umwandlung des elektrischen Signals in ein optisches Signal wird gering gehalten.

Figur 4 zeigt ein Funktionsblockschaltbild der Stromsensoreinheit 1 unter Einbindung eines Mikrocontrollers. Bei dieser ist eingangsseitig der Shunt 21 vorgesehen, der beim Durchfluss eines Stromes, nämlich der Messgröße bzw. des Messsignals, durch diesen Präzisionswiderstand eine indirekte Messung des zu erfassenden Stroms durch einen Spannungsabfall ermöglicht. Ausgangsgröße des Shunts ist daher eine Spannung, die als Messgröße dem Erfassungsmodul 12 zugeführt wird. Dieser ist in dem Ausführungsbeispiel nach Figur 4 z.B. ein IHM-A-1500 der Isabellenhütte Heusler GmbH & Co. KG. Das Erfassungsmodul 12 gibt einen 16-Bit-Wert des Messsignals an ein Modulationsmodul 16 weiter. Dieses splittet den 16-Bit-Messwert in zwei 8-Bit-Werte auf. Dies erfolgt durch eine Modulation, wie weiter unten noch näher erläutert werden wird. Die Pulsdauer des ersten 8-Bit-Werts ist mit $T_P$ angegeben, die Periodendauer des zweiten 8-Bit-Wertes mit $T_S$, wobei $T_S = T_P + T_{aus}$ ist. Die Periodendauer $T_S$ setzt sich somit aus der Dauer des Pulses $T_P$ und der Dauer des Low Signals ($T_{aus}$), zusammen. Die Pulsfolge ist in Figur 4 in einem vergrößerten Detailausschnitt angedeutet.

Durch die Modulation wird bei der Übertragung des Messsignals eine 16 Bit Auflösung erreicht, um eine Verfälschung des zu übertragenden Messsignals zu vermeiden. Als Modulationsmodul 16 wird insbesondere ein Mikrocontroller vorgesehen. Die Datenübertragungsstrecke der Stromsensoreinheit dient dazu, Messsignale von einer Leistungseinheit, beispielsweise einer leistungselektronischen Einrichtung, die den zu erfassenden Strom führt, an eine Visualisierungs-, Steuer- oder Automatisierungseinheit zu senden.

Der modulierte Messwert wird über das Übertragungsmodul 17 potentialfrei übertragen, beispielsweise über eine optische Strecke. Um den Messwert in der Steuerelektronik weiter verarbeiten zu können, erfolgt eine Demodulation in einem Demodulationsmodul 22. Hierbei werden aus der Periodendauer $T_S$ der zweite pulsweitenmodulierte 8 Bit Wert errechnet und aus der Pulsdauer $T_P$ der erste pulsweitenmodulierte 8 Bit Wert, wobei der Messwert sich aus der Summe der beiden 8 Bit Werte errechnet. Dieser Messwert wird über eine Ausgabeeinheit 23 ausgegeben und an die Steuerelektronik 50 weitergeleitet. Das Demodulationsmodul kann auch durch einen Mikrocontroller, der die Aufgaben der Steuerelektronik übernimmt, realisiert werden.

Bei dem erfindungsgemäßen Datenübertragungsverfahren in der Stromsensoreinheit 1 wird zunächst der Messwert bzw. die Messgröße gespiegelt. Es erfolgt dann eine Codierung unter Verwendung einer Frequenz-Pulsweiten-Modulation, da sich beispielsweise bei einer reinen Pulsweitenmodulation aufgrund der hohen Auflösung des zu übertragenden Messsignals eine hohe Taktfrequenz $f_T$ für die auswertende Einheit ergäbe. Nimmt man beispielsweise eine Trägerfrequenz $f_B$ von 32 kHz an, so wäre eine zeitliche Pulsweitenauflösung nach der Formel

$$T_{P,min} = 1/f_T = 1/f_B \cdot 1/2^C = T_P \cdot 1/2^C \text{ mit } f_T = f_B \cdot 2^C.$$

Hierbei ist die kleinste Änderung der Pulsdauer $T_{P,min}$. Mit einer Auflösung des zu übertragenden Signals von C = 16 Bit ergäbe sich eine zeitliche Pulsweitenauflösung von 0,47 ns bzw. eine Frequenz von 2,097 GHz. Für eine solch hohe Taktfrequenz sind jedoch nicht ohne Weiteres Mikrocontroller verfügbar bzw. gibt es zumindest keine Mikrocontroller im niederpreisigen Bereich, so dass das Vorsehen einer Stromsensoreinheit im kostengünstigen Bereich hier nicht möglich wäre. Daher wird erfindungsgemäß der 16 Bit Messwert in zwei 8 Bit Werte aufgeteilt, wobei sich für die vorstehenden Zahlenwerte eine neue Frequenz von 32 kHz x $2^8$ = 8,192 MHz ergäbe.

Der Signalwert wird durch die Aufteilung in zwei 8 Bit Werte, wobei ein 8 Bit Wert der High-Wert ist und ein 8 Bit Wert der Low-Wert ist, nachfolgend als Periode bzw. Einschaltzeit codiert. Wird für die Analog-Digital-Signalwandlung ein Präzisionserfassungsmodul, beispielsweise ein ASIC IHM-A-1500, verwendet, der als Erfassungsmodul 12 zum Erfassen der dem Strom proportionalen Spannung am Shunt 21 eingesetzt wird, kann zum Nutzen der maximal möglichen Wandlungsrate des Präzisionswandlers als kleinste Frequenz eine Frequenz von $f_0$ = 16 kHz vorgegeben werden. Durch die Taktfrequenz des auszuwertenden Mikrocontrollers wird die höchstmögliche zeitliche Auflösung des modulierten Signals $T_A$ bestimmt, wobei gilt, dass je höher die Auflösung ist, desto kleiner die Zeit ist. Dies erfolgt nach der Formel

$$T_A = 1/f_T \leq T_{P,min}.$$

Um die Frequenz $f_S$ des binären Signals zu erhalten, wird aus dem Wert der oberen 8 Bit die relative Änderung der Frequenz errechnet. Die hierbei berücksichtigte Wertigkeit wird als w bezeichnet und die high 8 Bit mit h. Die Formel für die Berechnung der Frequenz ergibt sich zu

$$f_S = f_0 + \frac{f_T}{255} \cdot \frac{w(h - 8\ Bit)}{255},$$

wobei w(h - 8 Bit) = 0 bis 255.

Die Frequenz des modulierten Signals $f_S$ variiert bei einer Taktfrequenz der auswertenden Einheit $f_T$ von 4 MHz zwischen 16 kHz bei einem Wert der oberen 8 Bit von w(h - 8 Bit) = 0 und 31,686 kHz bei einem Wert von w(h - 8 Bit) = 255. Die in diesem Beispiel zugrunde gelegte Taktfrequenz von 4 MHz kann auch bei niedrigpreisigen Mikrokontrollern realisiert werden. Ferner kann sie für die Modulation des Messsignals grundsätzlich für alle auswertenden Einheiten mit einer höheren Taktfrequenz als 4 MHz verwendet werden.

Alternativ kann die Periode $T_S$ mit folgender Formel berechnet werden:

$$T_S = \frac{1}{f_0} - \frac{255}{f_T} \cdot \frac{w(h - 8bit)}{255}.$$

Hiernach variiert die Frequenz des modulierten Signals $f_S$ bei einer Frequenz $f_0$ = 13,333 kHz und einer Taktfrequenz der auswertenden Einheit $f_T$ von 8 MHz zwischen 13,333 kHz bei einem Wert der oberen 8 Bit bei w(h-8bit) = 0 und 23,188 kHz bei w(h-8bit) = 255. Die beispielhaft zugrundegelegte Taktfrequenz von 8 MHz kann mit nahezu jedem Mikrocontroller realisiert werden, auch mit niederpreisigen. Sie kann ferner für die Modulation des Signals grundsätzlich für alle auswertenden Einheiten mit einer höheren Taktfrequenz als 8 MHz verwendet werden.

Für die Modulation des Messwertes der unteren 8 Bit wird je nach Wert der 8 Bit die Dauer des High-Pulses $T_P$ variiert. Die Änderung der Pulsdauer $T_P$ wird in Relation zu der Signalperiode bzw. Periodendauer $T_S$ berechnet. Um eine eindeutige Interpretation des ermittelten Signals zu gewährleisten und um die Periodendauer eindeutig zu erkennen, werden eine minimal erforderliche Pulsdauer $T_{P,min}$ und eine maximale Pulsdauer $T_{P,max}$ entsprechend den beiden Formeln

$$T_{P,min} = k_1 \cdot \frac{1}{f_S} \quad \text{und} \quad T_{P,max} = k_2 \cdot \frac{1}{f_S}$$

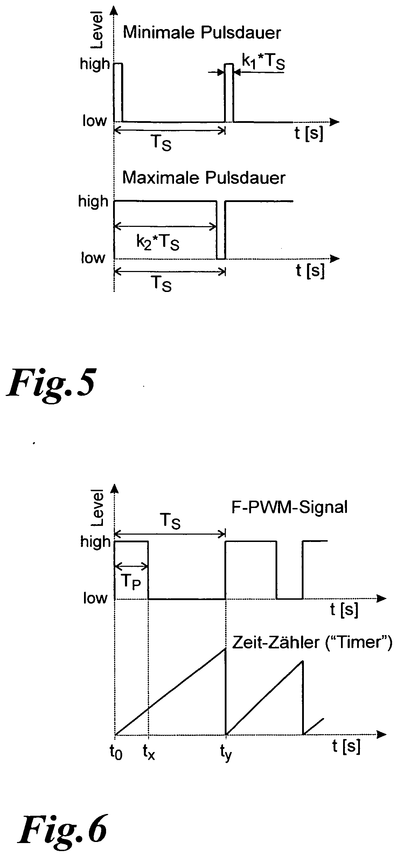

festgelegt. Dies ist auch in Figur 5 gezeigt.

Für Variablen $k_1$ und $k_2$ werden üblicherweise Werte von $k_1$ = 0,05 und $k_2$ = 0,95 verwendet. Die Pulsdauer $T_P$ kann im Verhältnis zu der Periodendauer $T_S$ nach folgender Formel berechnet werden, wobei I für die low 8 Bit steht:

$$T_P = \frac{k_1}{f_S} + \frac{(1 - k_1 - (1 - k_2))}{f_S} \cdot \frac{w(l - 8\ Bit)}{255}$$

mit w(I-8 Bit) = 0 bis 255.

Alternativ ist eine Berechnung der Pulsdauer $T_P$ in Relation zur Taktfrequenz $f_T$ nach folgender Formel möglich:

$$T_P = T_{P,min} + \frac{255}{f_T} \cdot \frac{w(l - 8\ Bit)}{255}.$$

Der Figur 5 können die minimale und die maximale Pulsdauer sowie die Periodendauer entnommen werden. Hier ist jeweils der Signalpegel zwischen Low und High gegenüber der Zeit aufgetragen. Die minimale Pulsdauer beträgt $k_1$ x $T_S$ und die maximale Pulsdauer $k_2$ x $T_S$, mit $T_S$ als der Periodendauer des Signals.

Die Auswertung des modulierten Signals wird entsprechend Figur 6 durchgeführt, wobei eine Auswerteeinheit die Zeit zwischen zwei steigenden Flanken des Messsignals ermittelt. Diese entspricht der bereits genannten Periodendauer $T_S$ des Signals mit $T_S$ = $t_y$ - $t_0$, wobei $t_0$ der Zeitpunkt der steigenden Flanke zu Beginn der Periodendauer und $t_Y$ der Zeitpunkt der steigenden Flanke am Ende der Periodendauer ist. Dies ergibt sich auch aus dem unteren Teil der Figur 6, wobei auch hier wiederum der Signalpegel gegenüber der Zeit aufgetragen ist.

Von der Auswerteeinheit wird zudem der Zeitpunkt $t_x$ erfasst, zu dem das Messsignal innerhalb der Periode von High auf Low umgeschaltet wird. Auch dies ist in Figur 6 gezeigt. Nach jeder steigenden Flanke weist entsprechend das modulierte Signal eine fallende oder negative Flanke auf. Hierüber kann die Dauer des High-Pulses bestimmt werden, entsprechend $T_P = t_x - t_0$.

Aus der Periodendauer $T_S$ des Signals bzw. der Frequenz wird entsprechend dem Modulationsalgorithmus der Wert der oberen 8 Bit errechnet und aus der Pulsdauer $T_P$ im Verhältnis zu der Periodendauer $T_S$ der Wert der unteren 8 Bit. Beide Werte werden in einen 16 Bit Speicher in binärer Form eingeschrieben und nachfolgend insbesondere in eine Hexadezimalzahl umgewandelt, um weiter verarbeitet werden zu können.

Neben den im Vorstehenden beschriebenen und in den Ausführungsbeispielen gezeigten Stromsensoreinheiten können noch zahlreiche weitere gebildet werden, bei denen zumindest ein Shunt zum Erfassen einer Größe, zumindest ein Signalerfassungsmodul, zumindest ein Modulationsmodul zur Frequenz-Pulsweiten-Modulation und ein potentialfreies Übertragungsmodul vorgesehen sind. Ferner können ein Demodulationsmodul und eine Ausgabeeinheit für einen Messwert vorgesehen sein.

Bezugszeichenliste

| | |
|---|---|
| 1 | Stromsensoreinheit |
| 10 | Stromanschluss |
| 11 | Stromanschluss |
| 12 | Erfassungsmodul |
| 13 | Datenleitung |
| 14 | Datenleitung |
| 15 | Datenleitung |
| 16 | Modulationsmodul |
| 17 | potentialfreies Übertragungsmodul |
| 18 | Ausgang |
| 19 | Hilfsenergieversorgungseinrichtung mit DC/DC-Wandler |
| 20 | Quarzoszillator |
| 21 | Shunt |
| 22 | Demodulationsmodul |
| 23 | Ausgabeeinheit |
| 40 | Optokoppler |
| 41 | Leitung |
| 42 | Lichtwellenleiter |
| 50 | Steuerelektronik |
| $T_P$ | Pulsdauer |
| $T_S$ | Periodendauer |
| $f_T$ | Taktfrequenz |
| $f_B$ | Trägerfrequenz |
| w | Wertigkeit |
| $t_0$ | Zeitpunkt der steigenden Flanke zu Beginn der Periodendauer |
| $t_Y$ | Zeitpunkt der steigenden Flanke am Ende der Periodendauer |
| $t_x$ | Zeitpunkt, zu dem Messsignal von High auf Low umgeschaltet wird |

**Patentansprüche**

1. Stromsensoreinheit (1) mit potentialfreier Signalübertragung,
   **dadurch gekennzeichnet, dass**
   zumindest ein Shunt (21) und zumindest ein Erfassungsmodul (12) zum Erfassen einer Messgröße, zumindest ein Modulationsmodul (16) zur Frequenz-Pulsweiten-Modulation und zumindest ein potentialfreies Übertragungsmodul (17) vorgesehen sind.

2. Stromsensoreinheit (1) nach Anspruch 1,
   **dadurch gekennzeichnet, dass**

zumindest ein Demodulationsmodul (22) oder eine Softwareroutine zur Demodulation des übertragenen modulierten Messsignals vorgesehen ist.

3. Stromsensoreinheit (1) nach Anspruch 1 oder 2,
   **dadurch gekennzeichnet, dass**
   das Übertragungsmodul (17) eine optische und/oder magnetische Übertragungsstrecke aufweist.

4. Sensoreinheit (1) nach Anspruch 1, 2 oder 3,
   **dadurch gekennzeichnet, dass**
   das Modulationsmodul (16) eine Codierung von 8 Bit des Messsignals in eine Pulsweite und von 8 Bit des Messsignals in eine Frequenz umfasst.

5. Stromsensoreinheit (1) nach einem der vorstehenden Ansprüche,
   **dadurch gekennzeichnet, dass**
   die Stromsensoreinheit (1) modular aufgebaut ist.

6. Stromsensoreinheit (1) nach einem der vorstehenden Ansprüche,
   **dadurch gekennzeichnet, dass**
   das Erfassungsmodul (12) zum Erfassen der dem am Shunt (21) erfassten Strom proportionalen Spannung ein Analog-Digital-Wandler mit einer programmierbaren Verstärkereinheit zum Erzielen einer hohen Auflösung ist.

7. Stromsensoreinheit (1) nach einem der vorstehenden Ansprüche,
   **dadurch gekennzeichnet, dass**
   das potentialfreie Übertragungsmodul (17) zumindest einen Optokoppler (40) und/oder Lichtwellenleiter (42,43) umfasst.

8. Verfahren zur Signal- und/oder Datenübertragung unter Verwendung einer Stromsensoreinheit (1) nach einem der vorstehenden Ansprüche, **dadurch gekennzeichnet, dass**
   die Übertragung realisiert wird durch ein Modulationsmodul zur Signal- und/oder Datenmodulation, ein Übertragungsmodul mit einer Sendeeinheit, eine potentialfreie Übertragungsstrecke und eine Empfangseinheit, wobei eine Codierung eines Messsignals durch eine Frequenz-Pulsweiten- Modulation erfolgt, wobei 8 Bit des Messsignalwerts in eine Pulsweite und 8 Bit des Messsignalwerts in eine Frequenz codiert werden.

9. Verfahren nach Anspruch 8,
   **dadurch gekennzeichnet, dass**
   bei einer Demodulation die zwei Zeiten zwischen zwei steigenden Flanken des Messsignals und der Zeitpunkt ($t_x$) des Umschaltens der Größe von High auf Low erfasst werden.

10. Verfahren nach Anspruch 9,
    **dadurch gekennzeichnet, dass**
    sich die Periodendauer ($T_S$) des zweiten 8-Bit-Wertes aus der Dauer des Pulses ($T_P$) des ersten 8-Bit-Werts und der Dauer des Low Signals ($T_{aus}$) zusammensetzt und aus der Periodendauer ($T_S$) oder Frequenz ein oberer 8-Bit-Wert und aus der Pulsdauer in Relation zu der Periodendauer des Messsignals ein unterer 8-Bit-Wert errechnet werden.

11. Verfahren nach Anspruch 10,
    **dadurch gekennzeichnet, dass**
    der obere und der untere 8-Bit-Wert in einem 16-Bit-Speicher in binärer Form eingeschrieben und/oder zur Auswertung in eine Hexadezimalzahl umgewandelt und ausgegeben werden.

**Claims**

1. A current sensor unit (1) with potential-free signal transmission,
   **characterised in that**
   at least one shunt (21) and at least one detection module (12) for detecting a measured variable, at least one modulation module (16) for frequency pulse width modulation and at least one potential-free transmission module (17) are provided.

**2.** A current sensor unit (1) according to claim 1,
**characterised in that**
at least one demodulation module (22) or a software routine for the demodulation of the transmitted modulated measurement signal is provided.

**3.** A current sensor unit (1) according to Claim 1 or 2,
**characterised in that**
the transmission module (17) has an optical and/or magnetic transmission path.

**4.** A sensor unit (1) according to Claim 1, 2 or 3,
**characterised in that**
the modulation module (16) comprises an encoding of 8 bits of the measurement signal into a pulse width and 8 bits of the measurement signal into a frequency.

**5.** A current sensor unit (1) according to one of the preceding claims,
**characterised in that**
the current sensor unit (1) has a modular construction.

**6.** A current sensor unit (1) according to one of the preceding claims,
**characterised in that**
the detection module (12) for detecting the voltage which is proportional to the current detected at the shunt (21) is an analogue to digital converter with a programmable amplifier unit for achieving a high resolution.

**7.** A current sensor unit (1) according to one of the preceding claims,
**characterised in that**
the potential-free transmission module (17) comprises at least one optocoupler (40) and/or optical fibre (42, 43).

**8.** A process for signal and/or data transmission using a current sensor unit (1) according to one of the preceding claims,
**characterised in that**,
the transmission is realised by a modulation module for signal and/or data modulation, a transmission module with a transmitter unit, a potential-free transmission path and a receiver unit, wherein an encoding of a measurement signal takes place by means of a frequency pulse width modulation, wherein 8 bits of the measurement signal value are encoded into a pulse width and 8 bits of the measurement signal value are encoded into a frequency.

**9.** A process according to Claim 8,
**characterised in that**
in a demodulation process, the two times between two rising edges of the measurement signal and the instant ($t_x$) when the variable is switched from high to low are detected.

**10.** A process according to Claim 9,
**characterised in that**
the period ($T_s$) of the second 8 bit value is composed of the duration of the pulse ($T_P$) of the first 8 bit value and the duration of the low signal ($T_{aus}$) and an upper 8 bit value is calculated from the period ($T_s$) or frequency and a lower 8 bit value is calculated from the pulse duration in relation to the period of the measurement signal.

**11.** A process according to Claim 10,
**characterised in that**
the upper and the lower 8 bit value are entered in a 16 bit memory in binary form and/or converted into a hexadecimal number and output for evaluation purposes.

**Revendications**

**1.** Unité de capteur de courant (1) à transmission de signaux sans potentiel,
**caractérisée en ce**
**que** sont prévus au moins un shunt (21) et au moins un module de détection (12) servant à détecter une grandeur de mesure, au moins un module de modulation (16) servant à la modulation de largeur d'impulsions et de fréquence et au moins un module de transmission (17) sans potentiel.

**2.** Unité de capteur de courant (1) selon la revendication 1,
**caractérisée en ce**
qu'au moins un module de démodulation (22) ou une routine logicielle servant à la démodulation du signal de mesure modulé transmis est prévu.

**3.** Unité de capteur de courant (1) selon la revendication 1 ou 2,
**caractérisée en ce**
que le module de transmission (17) présente un tronçon de transmission optique et/ou magnétique.

**4.** Unité de capteur (1) selon la revendication 1, 2 ou 3,
**caractérisée en ce**
que le module de modulation (16) comprend un codage à 8 bits du signal de mesure dans une largeur d'impulsions donnée et à 8 bits du signal de mesure dans une fréquence donnée.

**5.** Unité de capteur de courant (1) selon l'une quelconque des revendications précédentes,
**caractérisée en ce**
que l'unité de capteur de courant (1) présente une structure modulaire.

**6.** Unité de capteur de courant (1) selon l'une quelconque des revendications précédentes,
**caractérisée en ce**
que le module de détection (12) servant à détecter la tension proportionnelle au courant détecté sur le shunt (21) est un convertisseur analogique-numérique pourvu d'une unité d'amplification pouvant être programmée servant à obtenir une résolution élevée.

**7.** Unité de capteur de détection (1) selon l'une quelconque des revendications précédentes,
**caractérisée en ce**
que le module de transmission (17) sans potentiel comprend au moins un optocoupleur (40) et/ou une fibre optique (42, 43).

**8.** Procédé servant à transmettre des signaux et/ou des données en utilisant une unité de capteur de courant (1) selon l'une quelconque des revendications précédentes,
**caractérisé en ce**
que la transmission est réalisée par un module de modulation servant à la modulation de signaux et/ou de données, par un module de transmission pourvu d'une unité d'envoi, par un tronçon de transmission sans potentiel et par une unité de réception, dans lequel un codage d'un signal de mesure est effectué par une modulation de largeur d'impulsions et de fréquence, dans lequel 8 bits de la valeur de signal de mesure sont codés en une largeur d'impulsions donnée et 8 bits de la valeur de signal de mesure sont codés en une fréquence donnée.

**9.** Procédé selon la revendication 8,
**caractérisé en ce**
que dans le cas d'une démodulation, les deux temps entre deux flancs montants du signal de mesure et le moment ($t_x$) de la commutation de la grandeur de élevée à faible sont détectés.

**10.** Procédé selon la revendication 9,
**caractérisé en ce**
que la durée de période ($T_s$) de la deuxième valeur à 8 bits se compose de la durée de l'impulsion ($T_p$) de la première valeur à 8 bits et de la durée du signal faible ($T_{aus}$), et **en ce qu'**une valeur à 8 bits supérieure est calculée à partir de la durée de période ($T_s$) ou de la fréquence et qu'une valeur à 8 bits inférieure est calculée à partir de la durée d'impulsion en lien avec la durée de période du signal de mesure.

**11.** Procédé selon la revendication 10,
**caractérisé en ce**
que la valeur à 8 bits supérieure et la valeur à 8 bits inférieure sont inscrites dans une mémoire à 16 bits sous une forme binaire et/ou sont converties aux fins de l'analyse en un chiffre hexadécimal et sont éditées.

**Fig.1**

**Fig.2**

**Fig.3**

**Fig.4**

Minimale Pulsdauer

$k_1 * T_S$

$T_S$

Maximale Pulsdauer

$k_2 * T_S$

$T_S$

## Fig.5

F-PWM-Signal

$T_S$

$T_P$

Zeit-Zähler ("Timer")

$t_0$   $t_x$   $t_y$

## Fig.6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10027092 A1